# EUROPEAN PATENT SPECIFICATION

(11) **EP 0 440 384 B1**
(45) Date of publication and mention of the grant of the patent: **10.05.1995**
(21) Application number: 91300582.3
(22) Date of filing: 25.01.1991
(51) Int. Cl.: C23C 16/06, C23C 16/26, C23C 16/56, C23C 28/00

(54) **Method of bonding a diamond film to a substrate**
Verfahren zum Verbinden eines Diamantenfilms mit einem Substrat
Méthode pour relier un film en diamant sur un substrat

(30) Priority: 26.01.1990 GB 9001833
(43) Date of publication of application: 07.08.1991
(73) Proprietor: DE BEERS INDUSTRIAL DIAMOND DIVISION (PROPRIETARY) LIMITED, Johannesburg, Transvaal (ZA)
(72) Inventor: Sussmann, Ricardo Simon, Guildford, Surrey (GB)
(74) Representative: Ellis-Jones, Patrick George Armine

(56) References cited:
- EP-A- 0 166 708
- EP-A- 0 207 467
- EP-A- 0 319 926

## Description

### BACKGROUND TO THE INVENTION

This invention relates to a method of bonding a diamond or diamond-like film to a substrate.

The growth of diamond films or diamond-like films on substrates by chemical vapour deposition (CVD) methods are known in the art. These methods involve decomposing gaseous carbon compounds such as hydrocarbons or carbon monoxide in the presence of the substrate. The decomposition can be achieved using various methods including heat, radio frequency (RF) energy or microwave energy.

The diamond or diamond-like material produced by chemical vapour deposition is known as CVD diamond.

CVD diamond films deposited on a variety of substrates are finding a range of applications in areas such as cutting tools, heat sinks, wear-resistant surfaces and the like.

For many of these applications good adhesion of the CVD diamond film to the substrate is a prime consideration. However, good and reproducible adhesion has not proved to be easily achievable. This is particularly so for ceramic substrates such as silicon nitride and tungsten carbide. Delamination of the CVD diamond film occurs either spontaneously or during use. EP-A-0 319 926 describes a method for preparing a machining tool having a cladding layer of diamond formed by CVD techniques which comprises the steps of forming a film of diamond on a surface of a temporary substrate, bonding the diamond film by brazing to a surface of a base body of the machining tool and removing the temporary substrate.

EP-A-0166708 describes a process where a substrate containing ceramic and refractory material or formed by a noble metal is coated with a first layer of metals that form stable carbides and with a CVD-deposited layer of polycrystalline diamond; the first layer improves adhesion of the diamond layer.

EP-A-0207467 describes a method for preparing a microtone blade coated with a layer of diamond where the coated layer is heat treated at a temperature from 700 to 1300°C in an inert atmosphere to remove adsorbed hydrogen, carbon-hydrogen radicals and the like.

According to the present invention, a method of producing a product comprising a diamond or diamond-like film bonded to a substrate includes the steps of providing the substrate, applying a layer of a bonding metal to a surface of the substrate, depositing a diamond or diamond-like film on the metal layer by chemical vapour deposition to produce a composite, and heating the composite under conditions so as to inhibit degradation of the diamond or diamond like film at a temperature at or above that at which diamond growth by diamond vapour deposition takes place in an inert, non-oxidising or reducing atmosphere or in a vacuum to cause the metal layer to bond the film to the substrate.

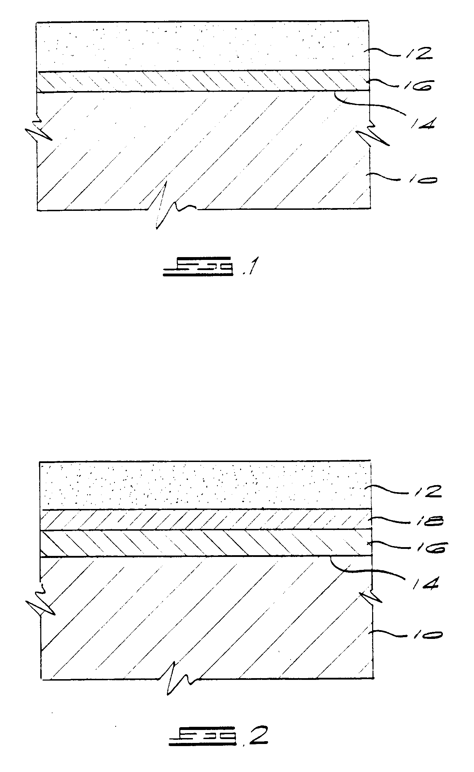

Figures 1 and 2 illustrate schematically different embodiments of the invention.

### DESCRIPTION OF EMBODIMENTS

The invention utilises the ability of certain metals to wet and bond to diamond and to various substrates. The metal will vary according to the nature of the substrate. The metals which are useful in the practice of the invention can be pure metals or alloys.

Examples of suitable alloys for use with ceramic substrates are those which contain an active metal, i.e. a metal which is capable of forming a carbide. Examples of such active metals are titanium, molybdenum, hafnium, niobium, tantalum and chromium. Typically, the other metals in the alloy will be copper, gold, nickel and silver and mixtures thereof. Examples of suitable alloys are a copper/silver alloy containing an active metal and a gold/silver/tantalum/titanium alloy.

The substrate may be any known in the art, but will typically be ceramic in nature. Examples of suitable substrates are carbides such as tungsten carbide or silicon carbide, nitrides such as silicon nitride and sialon.

The heating of the composite will take place under conditions which allow bonding between the film and the substrate to take place. It is also important that the conditions are such as to inhibit degradation of the diamond or diamond-like film. The heating will take place in an inert, non-oxidising or reducing atmosphere or in a vacuum at a temperature at or above that at which diamond growth takes place, typically of the order of 700°C to 1100°C.

The diamond or diamond-like film is deposited on the metal layer by any chemical vapour deposition method known in the art. It may be deposited directly on a surface of the metal layer. Alternatively, a layer of a protective material may be sandwiched between the metal layer and the diamond or diamond-like film. The protective layer may be used to protect the metal layer from degradation during the CVD deposition and/or subsequent heat treatment.

Typically, the thickness of the CVD diamond film will be from 5 microns up to a few thousand, e.g. 3000 microns.

Embodiments of the invention will now be described. Referring first to Figure 1, there is shown a substrate 10 having CVD diamond film 12 bonded to a surface 14 thereof through a metal bonding layer 16. The metal layer 16 is deposited on the surface 14 of the substrate and the diamond film then deposited on the metal layer using any CVD method. The coated substrate is sintered in a vacuum oven at a temperature exceeding 900°C in order to bond the CVD diamond film to the substrate through the metal layer.

The CVD deposition process is carried out either in a highly reducing atmosphere containing a high concentration of atomic hydrogen or in an oxidising atmosphere containing atomic oxygen or halogens. This environment may attack the metal bonding layer by forming hydrides, oxides or halides. To minimise this problem, a layer of a protective material may be sandwiched between the CVD diamond film and the metal bonding layer. Examples of protective materials are metals such as gold, silver and platinum and other materials such as silicon and silicon nitride. This embodiment is illustrated by Figure 2 where like parts carry like numerals. The protective material layer is numbered 18.

In place of the protective materials set out above, a layer of another protective material may be used, for example, a coating of a thin layer of amorphous or diamond-like carbon can be deposited on the metal layer 16 using any of a variety of techniques such as radio frequency plasma assisted CVD at temperatures of the order of 300°C, radio frequency (RF) sputtering, ion beam sputtering or dual beam assisted sputtering.

A combination of a first protective metal layer and a second protective material layer may also be used.

During the deposition of the CVD diamond or diamond-like film it is possible that some interdiffusion between the metal and protective layers 16, 18 could take place. To prevent this a thin layer of a "diffusion barrier" of a material such as platinum or titanium nitride may be interposed between the layers 16, 18.

## Claims

1. A method of producing a product comprising a diamond or diamond-like film (12) bonded to a substrate (10) includes the steps of providing a substrate (10), applying a layer (16) of a bonding metal to a surface (14) of the substrate (10), depositing a diamond or diamond-like film (12) on the metal layer (16) by chemical vapour deposition to produce a composite, and heating the composite under conditions so as to inhibit degradation of the diamond or diamond like film at a temperature at or above that at which diamond growth by chemical vapour deposition takes place in an inert, non-oxidising or reducing atmosphere or in a vacuum to cause the metal layer (16) to bond the film (12) to the substrate (10).

2. A method according to claim 1 wherein the substrate (10) is a ceramic substrate and the metal layer (16) is an alloy containing a metal capable of forming a carbide.

3. A method according to claim 2 wherein the carbide-forming metal is selected from titanium, molybdenum, hafnium, niobium, tantalum and chromium.

4. A method according to claim 3 wherein the other metal in the alloy is selected from copper, gold, nickel and silver and mixtures thereof.

5. A method according to any one of claims 2 to 4 wherein the ceramic substrate (10) is selected from carbides, nitrides and sialon.

6. A method according to any one of the preceding claims wherein a layer (18) of a protective material is deposited on the metal layer (16) prior to the deposition of the diamond or diamond-like film (12).

7. A method according to claim 6 wherein the protective material is selected from gold, silver, platinum, silicon, silicon nitride and amorphous carbon.

8. A method according to claim 6 wherein a combination of a first layer of a protective metal and a second layer of a protective material is deposited on the metal layer (16) prior to the deposition of the diamond or diamond-like film.

9. A method according to claim 6 wherein a layer of a diffusion barrier is interposed between the layer (18) of a protective material, and the metal layer (16).

10. A method according to any one of the preceding claims wherein the thickness of the diamond or diamond-like film (12) is from 5 microns up to a few thousand microns.

11. A method according to any one of the preceding claims wherein the heating takes place at a temperature of 700°C to 1100°C.

## Patentansprüche

1. Verfahren zur Herstellung eines Produkts, das einen Diamant- oder diamantartigen Film (12) umfaßt, der an ein Substrat (10) gebunden ist, umfassend die Stufen der Bereitstellung eines Substrats (10), des Aufbringens einer Schicht (16) eines bindenden Metalls auf eine Oberfläche (14) des Substrats (10), des Abscheidens eines Diamant- oder diamantartigen Films (12) auf der Metallschicht (16) durch chemische Dampfabscheidung, um ein Composit herzustellen, und Erhitzens des Composits unter Bedingungen, um so Zersetzung des Diamant- oder diamantartigen Films zu verhindern, bei einer Temperatur bei der, oder oberhalb derjenigen, Diamantenwachstum durch chemische Dampfabscheidung in einer inerten, nicht-oxidierenden oder reduzierenden Atmosphäre oder in einem Vakuum stattfindet, um die Metallschicht (16) zu veranlassen, den Film (12) an das Substrat (10) zu binden.

2. Verfahren gemäß Anspruch 1, worin das Substrat (10) ein keramisches Substrat ist und die Metallschicht (16) eine Legierung ist, die ein Metall enthält, das ein Carbid bilden kann.

3. Verfahren gemäß Anspruch 2, worin das carbidbildende Metall aus Titan, Molybdän, Hafnium, Niob, Tantal und Chrom ausgewählt ist.

4. Verfahren gemäß Anspruch 3, worin das andere Metall in der Legierung aus Kupfer, Gold, Nickel und Silber und deren Mischungen ausgewählt ist.

5. Verfahren gemäß irgendeinem der Ansprüche 2 bis 4, worin das keramische Substrat (10) aus Carbiden, Nitriden und Sialon ausgewählt ist.

6. Verfahren gemäß irgendeinem der vorhergehenden Ansprüche, worin eine Schicht (18) eines schützenden Materials auf der Metallschicht (16) vor dem Abscheiden des Diamant- oder diamantartigen Films (12) abgeschieden wird.

7. Verfahren gemäß Anspruch 6, worin das schützende Material aus Gold, Silber, Platin, Silicium, Siliciumnitrid und amorphem Kohlenstoff ausgewählt ist.

8. Verfahren gemäß Anspruch 6, worin eine Kombination aus einer ersten Schicht aus einem schützenden Metall und einer zweiten Schicht aus einem schützenden Material auf der Metallschicht (16) vor dem Abscheiden des Diamant- oder diamantartigen Films abgeschieden wird.

9. Verfahren gemäß Anspruch 6, worin eine Schicht aus einer Diffusionsbarriere zwischen der Schicht (18) aus einem schützenden Material und der Metallschicht (16) angeordnet ist.

10. Verfahren gemäß irgendeinem der vorhergehenden Ansprüche, worin die Dicke des Diamant- oder diamantartigen Films (12) 5 »m bis einige tausend »m beträgt.

11. Verfahren gemäß irgendeinem der vorhergehenden Ansprüche, worin das Erhitzen bei einer Temperatur von 700 °C bis 1100 °C erfolgt.

## Revendications

1. Procédé pour la préparation d'un produit comprenant une pellicule de diamant ou d'une substance analogue au diamant (12) soudé sur un substrat (10) qui comprend les étapes constitant à fournir un substrat (10), à appliquer une couche (16) d'un métal de liaison sur une surface (14) du substrat (10), à déposer une pellicule de diamant ou une substance analogue au diamant sur la couche métallique (16) par déposition en phase gazeuse par procédé chimique pour produire un composite, et à chauffer le composite dans des conditions telles à inhiber la dégradation de la pellicule de diamant ou d'une substance analogue au diamant à une température située à ou au dessus de la température à laquelle la croissance de diamant se produit par déposition en phase gazeuse par procédé chimique sous atmosphère inerte non oxydante ou réductrice ou sous vide pour faire lier la pellicule (12) sur le substrat (10) par la couche métallique (16).

2. Procédé selon la revendication 1 dans lequel le substrat (10) est un substrat céramique et la couche métallique (16) est un alliage contenant un métal capable de former un carbure.

3. Procédé selon la revendication 2, par lequel le métal formant carbure est choisi parmi le titane, le molybdène, l'hafnium, le niobium, le tantale et le chrome.

4. Procédé selon la revendication 3, dans lequel l'autre métal dans l'alliage est choisi parmi le cuivre, l'or, le nickel et l'argent et leurs mélanges.

5. Procédé selon l'une quelconque des revendications 2 à 4, dans lequel le substrat céramique (10) est choisi parmi les carbures, les nitrures et le sialon.

6. Procédé selon l'une quelconque des revendications précédentes dans lequel une couche (18) d'un matériau protecteur est déposé sur la couche métallique (16) avant déposition de la pellicule de diamant ou de substance analogue au diamant (12).

7. Procédé selon la revendication 6, dans lequel la matière protectrice choisie est l'or, l'argent, le platine, le silicium, le nitrure de silicium et le carbone amorphe.

8. Procédé selon la revendication 6, dans lequel on dépose une combinaison d'une première couche d'un métal protecteur et d'une seconde couche d'un matériau protecteur sur la couche métallique (16) avant la déposition de la pellicule de diamant ou de la pellicule d'une substance analogue au diamant.

9. Procédé selon la revendication 6, dans lequel on intercale une couche d'une barrière de diffusion entre la couche (18) d'une matière protectrice et la couche métallique (16).

10. Procédé selon l'une quelconque des revendications précédentes, dans lequel l'épaisseur de la pellicule de diamant ou de la substance analogue au diamant (12) est de 5 microns jusqu'à quelques milliers de microns.

11. Procédé selon l'une quelconque des revendications précédentes, dans lequel le chauffage s'effectue à une température de 700 à 1100°C.
